(19) Europäisches Patentamt
European Patent Office
Office européen des brevets

(11) **EP 4 539 090 A1**

(12) **EUROPEAN PATENT APPLICATION**

(43) Date of publication:
16.04.2025 Bulletin 2025/16

(21) Application number: 23203083.3

(22) Date of filing: 11.10.2023

(51) International Patent Classification (IPC):
*H01J 37/153* (2006.01)   *H01J 37/22* (2006.01)

(52) Cooperative Patent Classification (CPC):
**H01J 37/153; H01J 37/222;** H01J 2237/1534

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **FEI Company**
**Hillsboro, OR 97124-5793 (US)**

(72) Inventors:
• **FRANKEN, Erik**
  **5651 GG Eindhoven (NL)**
• **DENG, Yuchen**
  **5651 GG Einhoven (NL)**

(74) Representative: **Korenberg, Alexander Tal et al**
**Kilburn & Strode LLP**
**Lacon London**
**84 Theobalds Road**
**London WC1X 8NL (GB)**

(54) **CORRECTION OF OPTICAL ABERRATIONS IN CHARGED PARTICLE BEAM MICROSCOPY**

(57) A charged particle beam microscope system is operated and directs a charged particle beam to a sample to produce a plurality of images for a plurality of areas of the sample. Respective first sets of one or more aberration predictor values are acquired for each of the plurality of images. During the image acquisition, an aberration measurement and a corresponding second set of aberration predictor values are periodically acquired. An aberration model is obtained using the aberration measurements the corresponding second sets of aberration predictor values, wherein the model takes a set of aberration predictor values as an input and outputs predicted aberration data. The model is applied to the first sets of aberration predictor values to obtain respective aberration data, which is used to reduce or at least partially correct for aberration in the charged particle microscope images. A sample reconstruction is obtained using the acquired charged particle microscope images.

FIG. 1

EP 4 539 090 A1

## Description

### FIELD

The disclosure relates to correcting aberrations in charged particle beam microscopy, specifically but not exclusively electron microscopy.

### BACKGROUND

Transmission electron microscopy (TEM) is a technique in which a beam of electrons is transmitted through a thin sample to form an image. The image is formed by the interaction of the electrons with atoms of the sample as the electrons are transmitted through the sample. The image can be captured by a camera. TEM is capable of producing high resolution images due to the small wavelength of the transmitted electrons. Sufficiently high-resolution images can be used to investigate and analyse the structural details of the sample on an atomic scale. However, optical aberrations in the microscope can limit the resolution of the images.

### BRIEF DESCRIPTION OF THE DRAWINGS

FIG. 1 is a block diagram of a system for measuring and correcting optical aberrations in a charged particle beam microscope system operating in a transmission imaging mode, in accordance with various implementations.

FIG. 2 is a flow diagram of a specific example method for acquiring an aberration measurement, as may optionally be used to facilitate various implementations described below.

FIG. 3 is a flow diagram of a workflow for the acquisition of aberration data in accordance with various implementations.

FIGs. 4a and 4b are flow diagrams of workflows for the processing of the acquired aberration data to correct the charged particle microscope image, in accordance with various implementations.

FIG. 5 is a flow diagram of a workflow for the processing of the acquired aberration data to tune the charged particle beam microscope system, in accordance with various implementations.

FIG. 6 is a block diagram of a generalized computing system of a suitable computing environment that may be used in methods implementing monitoring and correction of optical aberrations in a charged particle beam microscope system.

### DETAILED DESCRIPTION

The subject matter disclosed herein pertains to improved methods and systems for obtaining a sample reconstruction. In particular, the subject matter disclosed herein pertains to methods and systems for imaging in charged particle beam microscope systems (e.g., operating in a transmission imaging mode or a scanning imaging mode) while obtaining a model relating to aberrations in the system, which is used to reduce or at least partially correct for the aberrations. Examples of optical aberrations that can be corrected include, but are not limited to, defocus, two-fold astigmatism, three-fold astigmatism, four-fold astigmatism, five-fold astigmatism, sixfold astigmatism, axial coma, fifth order axial coma, spherical aberration, sixth order spherical aberration, star aberration, sixth order star aberration, three-lobe aberration, rosette aberration, linear distortion, pincushion distortion, barrel distortion, spiral distortion, and elliptical distortion. Specific embodiments of charged particle beam microscope systems relate to electron microscopy systems. The disclosure therefore includes aspects and embodiments as set out in which the charged particles are electrons.
Sample reconstruction may refer to methods to extract information from a plurality of acquired images and carry out a reconstruction. An example of such a reconstruction is a (3D) structure reconstruction, a 3D-model, an exit wave reconstruction, a 3D atomic resolution reconstruction, or a surface image (as in the case of the scanning imaging mode). The images may be acquired through any imaging workflow. Some such workflows acquire many images at different sample positions, such as, but not limited to, single particle analysis or electron tomography. It will be understood that the sample position refers to one or both of the axial position (e.g., the x/y/z coordinates) of the sample and the rotation/tilt of the sample.

In one or more implementations, a method of acquiring a plurality of charged particle microscope images for sample reconstruction comprises acquiring a plurality of charged particle microscope images for a plurality of areas of a sample using a charged particle beam microscope system, e.g., an electron microscope system . The method comprises acquiring a respective first set of aberration predictor values for each acquisition of the plurality of charged particle microscope images, for example a temperature of the optical system of the charged particle microscope, a position and/or configuration of the optical system of the charged particle microscope, and so forth. Periodically an aberration measurement and a corresponding second set of aberration predictor values are acquired while acquiring the plurality of charged particle microscope images. The method further comprises obtaining an aberration model using the second sets of aberration predictor values and aberration measurements, e.g., by training or updating the model with the second sets of aberration predictor values and aberration measurements, or by reading the model from a memory. The model takes a set of aberration predictor values as an input and outputs predicted aberration data. The model is applied to the first sets of aberration predictor values to obtain respective predicted aberration data, which is used to reduce or at least partially correct for aberration. The aberration data may be used to (at least partially) correct for aberration in the charged particle microscope image data, and/or may be used to reduce aberration by tuning the charged particle beam microscope system during image acquisition (thereby reducing aberration in the subsequently acquired images). In any case, a sample reconstruction is obtained using the acquired charged particle microscope images, the first sets of aberration predictor values, and the aberration model.

The aberration predictor values may comprise any system parameters on which aberrations are known to be dependent, or parameters from which an aberration determination may otherwise be predicted. For example, aberration predictor values may comprise a two-dimensional position reading of the electron beam, a time stamp, a temperature, a sensor measurement from a surface of the imaging system, the sample position reading (e.g., x/y/z position and/or sample tilt), or any other environmental or operational variables which may impact the imaging system or the optical state of the system.

The optical state may comprise the parameters defining the optical elements of a system, which may drift or otherwise fluctuate, e.g., due to the variables discussed above. Such parameters defining the optical elements of a system may include, for example, a two- or three-dimensional position of the beam, a de(focus) or magnification of the beam, a state of magnetic or electrostatic deflectors, a state of one or more magnetic or electrostatic lens(es) The optical state of the system can change an unknown amount during a data acquisition session. However, the optical state can be tuned by adjusting the settings of magnetic or electrostatic deflectors, and the settings of the magnetic or electrostatic lens(es), e.g., by varying supply currents or voltages. Furthermore, the images acquired from the microscope column can be corrected, accounting for the changing optical state of the system. By obtaining an aberration model, the workflow of an imaging or data acquisition session is rendered more robust against less than perfect circumstances, such as changes of the parameters defined above. In particular, the parameter changes and their consequent aberrations may be more closely 'followed' over the data acquisition session without requiring additional aberration measurements, resulting in, for example, higher resolutions and/or more accurate 3D-models of the sample.

The aberration model may be any of various suitable classes of model. In some examples, the aberration model may be a parametric model with key system parameters as input. In some examples, the model may be a physical model, a statistical model, a linear model, a polynomial model, a decision tree, a random forest, a neural network, or a machine learning model.

The aberration model can also be described with reference to its inputs and outputs. In particular, a set of aberration predictor values is input into the aberration model. More specifically, the aberration model may take any system parameters upon which aberrations are known to be dependent as an input, the system parameters being acquired for each of the plurality of charged particle microscope images. Predicted aberration data is then output for the aberration model. It will be appreciated that the predicted aberration data may define the predicted aberration(s), or may define a correction or system adjustment for potential aberration(s). In particular, the predicted aberration data may include parameters specifying the type and numerical properties of one or more aberrations that may be present. The properties may comprise at least one of a magnitude or a direction of one or more aberrations, such as coma, or a set of values indicating the aberration properties of a set of identified aberrations, for example coma and spherical aberration, or any other form of data which may characterize one or more aberrations so that the characterized aberrations can be reduced or corrected for, e.g., by applying a correction transformation to the respective data acquisition and/or applying a settings adjustment to the microscope system based on the predicted aberration data in a subsequent step. In particular, the output predicted aberration data of the model comprises parameters specifying an image correction or a settings adjustment for the microscope system, and thus the output of the aberration model may be used directly to specify an operation that reduces or at least partially corrects for predicted distortive effects of aberrations. The correction or system adjustment can be applied as appropriate (e.g., a correction to the respective charged particle microscope image, or an adjustment to the microscope system) to reduce aberration prior to obtaining a sample reconstruction.

In one or more examples, the respective predicted aberration data comprises one or more aberration corrections for applying to the charged particle microscope image. In such examples, the respective predicted aberration data is used to correct for aberration(s) in the charged particle microscope image of each acquisition, and the corrected charged particle microscope images are used in sample reconstruction.

In some examples, the respective predicted aberration data may characterize one or more aberrations, such as, for example, defocus, astigmatism, coma, spherical, star, three-lobe, rosette, linear distortion, pincushion distortion, barrel distortion, spiral distortion, elliptical distortion or other aberrations. In such examples, correcting the charged particle microscope image may comprise computing an aberration correction for the charged particle microscope image from the respective predicted aberration data and correcting the charged particle microscope image using the computed aberration correction.

In some examples, the respective predicted aberration data may characterize one or more aberration corrections which can be used to correct for aberrations in the charged particle microscope images for sample reconstruction. In such examples, the predicted aberration data may comprise parameters specifying a transformation that can be used to correct for aberration in an image, for example including a scaling, rotation and/or skewing operation, or a Fourier filter. For example, the transformation can be a distortion field that corrects for the aberration. It will be appreciated that determining a correction (of any form) for a known aberration can be achieved using numerical methods and/or algorithms known in the art, such as those reviewed by Amit Singer et al [URL: https://arxiv.org/abs/2003.13828], which is incorporated herein by reference. Thus, in this example, using the output(s) of the aberration model, the distortive effects of aberrations can be corrected following data-acquisition in a post-processing step. By correcting for aberrations in post-processing, there is a reduced need to acutely monitor the imaging systems to correct for aberrations during data acquisition. Nevertheless, the image corrections may also be determined on-the-fly on the microscope during image acquisition. In particular, one or more model fitting or image correction steps as described herein may be carried out while data acquisition is ongoing, e.g., in order to limit processing latency.

In one or more examples, once predicted aberration data is obtained, it is determined whether the respective predicted aberration data meets a condition indicating that the charged particle microscope system needs to be tuned or indicating that aberrations are present which need to be reduced. In some examples, if the condition, which may be a predetermined threshold of a value of an aberration or of an adjustment, is met, the charged particle microscope system is tuned to reduce aberration.

In some examples, the predicted aberration data may comprise parameters specifying adjustments to the settings of the optical system, such as an adjustment of the electrical current applied to one or more components of the optical system, to tune components of the optical system and mitigate one or more potential aberrations during image acquisition. In other examples, the predicted aberration data characterises one or more aberrations such as, for example, defocus, astigmatism, coma, spherical, star, three-lobe, rosette, linear distortion, pincushion distortion, barrel distortion, spiral distortion, elliptical distortion or other aberrations. In such examples, the charged particle beam microscope system can be tuned by computing one or more adjustments for the charged particle beam microscope system from the predicted aberration data and applying the adjustment(s) to the necessary components of charged particle beam microscope system. It will be appreciated that, in the case of large inferred aberration values, it may be better to apply adjustments to the optical elements of the microscope to reduce aberration on-the-fly during acquisition. In the case of smaller aberrations, corrections may be more easily applied to the images, e.g., to correct for aberration in post-processing. These techniques may thus be used in combination, for example, if the condition indicating that the microscope system needs to be tuned is not met, the predicted aberration data may still indicate that a (small) aberration is present which can be corrected for with a correction to the corresponding acquired image / data acquisition.

In some examples, the method comprises, while acquiring images, periodically inferring aberration data and determining if the adjustment condition is met, and, subsequent to tuning the charged particle beam microscope system, continuing to acquire images. For example, the periodic aberration data inference can be every acquisition, after every n acquisitions, or according to a rule (e.g., the periodic acquisition may be triggered by sensors on the microscope system). After the periodic acquisition, the images may be continue to be acquired but now using the adjusted microscope system, i.e., with reduced aberration following the adjustment.

In one or more examples, the predicted aberration data may characterize or correct for a coma aberration, or for a plurality of aberrations, including coma, spherical, or otherwise.

In some examples, the aberration model may comprise a plurality of models for various aberrations. For example, the aberration model may comprise a plurality of separate models to characterize each of a plurality of aberrations, e.g., one model per aberration. In other examples, the aberration model may be a single model with one or more outputs for the respective one or more aberrations. In this way, models for different aberrations may be computed separately and applied one by one, e.g., with sequential aberration correction and/or sample reconstruction, or a joint multi-output model for a plurality of aberrations may computed and applied for a broad aberration mitigation and/or sample reconstruction.

In some examples, the aberration predictor values comprise any or more of the following: one or more temperature values, the temperature values corresponding to a respective one or more temperature sensors; a time stamp of the acquisition;; an optical state of the charged particle beam microscope system; a measurable physical state of the charged particle beam microscope system; a sensor measurement from a surface of the imaging system; a sample position reading; and/or a position reading of optics of the charged particle microscope. By training a model on periodically acquired aberration predictor values comprising the above, the imaging process is rendered more robust to temperature or other system changes over time, thereby allowing for a higher resolution sample reconstruction to be achieved consistently. Furthermore, there is a reduced need for acute monitoring and correcting of the imaging system during data acquisition.

In one or more examples, periodically acquiring an aberration measurement can comprise obtaining an aberration measurement for each charged particle microscope image. For example, the aberration measurement acquisition may be carried out following each exposure. In this way, the first part of the exposure is used for the acquisition of the charged particle microscope image, which is beneficial for samples which may be radiation sensitive.

Obtaining an aberration measurement for each charged particle microscope image may comprise obtaining one or more aberration measurements with a low precision (e.g., with significant noise on the estimate of the aberration value). By fitting and applying a model when taking low precision measurements with each exposure, the noise in the measurements can be effectively averaged out, and hence the low precision measurements can be 'denoised'.

In one or more examples, an aberration measurement may be obtained periodically during image acquisition, for example between 1 to 200 image acquisitions per aberration measurement, such as an aberration measurement every 20 image acquisitions.

The aberration measurement used for training the model may comprise one or more of the following: one or more images, acquired while changing one or more microscope parameters; one or more images which can be processed to obtain one or more aberration parameters; and/or a parameter characterizing aberration. For example, one or more images may be acquired while changing beam tilt. In such examples, the one or more images (or the shifts between them) may be indicative of the presence of one or more aberration and can therefore be processed to obtain one or more aberration parameters.

Parameters characterising aberration are known in the art and may comprise, for example, Thon ring analysis. Such aberration-characterising parameters and methods are discussed for example in Barthel J, Thust A "Aberration measurement in HRTEM: implementation and diagnostic use of numerical procedures for the highly precise recognition of diffractogram patterns", Ultramicroscopy, Volume 111, Issue 1, 2010, Pages 27-46, which is incorporated herein by reference.

A parameter characterizing aberration may also comprise image shifts across the acquired plurality of images. In a specific example, a test pattern is applied to beam-tilt coils in the microscope column and the resulting beam tilt leads to aberration-induced image shifts across the acquired plurality of images, for example as discussed in EP 4235731 A1. In this specific example, while operating the charged particle beam microscope system in a transmission imaging mode and directing a charged particle beam to a sample, a time series of beam tilts is applied in a pattern to the charged particle beam to produce a sequence of images. At least some of the images in the sequence of images are captured while the charged particle beam is transitioning between one beam tilt in the time series of beam tilts and a sequentially adjacent beam tilt in the time series of beam tilts. The sequence of images may be analysed according to the methods disclosed herein to obtain a sample reconstruction. In this specific example, the image of a test pattern refers to a pattern which is configured such that the beam tilts induce image changes (e.g., image shifts) in the sequence of images that can be correlated to optical aberrations in the microscope system. For example, image changes can be determined from the sequence of images and used to estimate one or more optical aberration values for the microscope system, and/or the one or more optical aberration values can be determined by a trained neural network that receives the sequence of images or information derived from the sequence of images (e.g., power spectra of the images) as input data. In this specific example of an aberration measurement, the beam tilt pattern is a periodic pattern, such as a Lissajous figure. The use of periodic patterns can make it possible to determine an unknown time delay and unknown deviation in frequency of the applied beam tilt pattern in relation to the measured image changes over time. The periodic patterns can also enable a system that is robust against other effects that can induce image changes (e.g., specimen drift and mechanical vibrations), allowing signal processing to be used to separate the different signal sources.

In some examples, the sample reconstruction comprises a Single Particle Analysis (SPA) reconstruction and/or a three-dimensional reconstruction. The sample reconstruction may comprise or be based on a charged particle microscope acquisition in which many images are acquired at different sample positions. For example, the sample reconstruction may be for electron tomography reconstruction.

In some implementations, a charged particle beam microscope system may comprise one or more memories which store computer-readable instructions configured to cause one or more processors to perform operations comprising methods as described above.

In some implementations, a computer-readable medium comprises instructions to be executed by one or more data processing apparatuses, which, when executed cause the respective one or more apparatuses to perform operations comprising methods as described above.

In one or more implementations, a method of training an aberration model for reducing or at least partially correcting aberration in a sample reconstruction comprises accessing previously acquired pairs of sets of aberration predictor values and corresponding aberration measurements and using the pairs to train the model. The obtained aberration model takes a set of aberration predictor values as an input and outputs predicted aberration data. In some examples, a reconstruction or improved resolution of an imaged sample may be obtained using the aberration model to reduce or at least partially correct for aberration in charged particle microscope images. Training the model comprises providing the acquired set of predictor values as inputs to the aberration model, obtaining outputs of the aberration model in response to the set of predictor values, and comparing the outputs of the model with the corresponding known aberration measurements for each input set of predictor values. The input aberration predictor values comprise: one or more temperature values (each temperature value corresponding to respective one or more sensors or to different acquisition times); a time of obtaining the aberration measurement; a sample position; an optical state of the charged particle beam microscope system; a measurable physical state of the charged particle beam microscope system; and/or a position of optics of the charged particle beam microscope system. The parameters of the model are then updated and/or tuned to reduce the error between the output values and the known aberration data. Training may comprise using the aberration measurements to train the model, such that the predicted aberration data characterises the aberration, or, alternatively, training may comprise determining parameters defining a correction at least partially correcting for aberration in an image or an adjustment to the charged particle beam microscope system reducing aberrations corresponding to the aberration measurement, and using the determined parameters to train the model, such that the predicted aberration data characterises the correction and/or the adjustment. Various methods of training the model are known in the art and suitable for the methods disclosed herein. For example, the model may be a deep learning model, such as an artificial neural network (ANN). ANN can be trained using gradient descent, stochastic gradient descent or other optimization algorithms like ADAM, as is well known in the field of ANN. The model may be any other parametric model, for example a physical model of aberration, a polynomial model, etc, with the parameters updated to reduce the error using any suitable optimization routine, including those mentioned above.

In one or more implementations, a method of acquiring a plurality of charged particle microscope images for sample reconstruction comprises acquiring a plurality of charged particle microscope images for a plurality of areas of a sample. The method comprises acquiring a respective first set of aberration predictor values for each of the plurality of charged particle microscope images, for example a temperature of the optical system of the charged particle beam microscope system, a position and/or configuration of the optical system of the charged particle beam microscope system, and so forth. A sample reconstruction is obtained using the acquired charged particle microscope images. In these implementations, a model is pre-trained and/or a pre-trained model is used for image reconstruction and/or charged particle microscope system adjustment, without necessarily obtaining or updating the model using the images acquired for the reconstruction. In this way, obtaining the aberration model may merely comprise reading a trained aberration model from a memory. The examples described above are equally applicable to these implementations in an analogous manner.

The subject matter is described with implementations and examples. In some cases, as will be recognized by one skilled in the art, the disclosed implementations and examples may be practiced without one or more of the disclosed specific details, or may be practiced with other methods, structures, and materials not specifically disclosed herein. All the implementations and examples described herein and shown in the drawings may be combined without any restrictions to form any number of combinations, unless the context clearly dictates otherwise, such as if the proposed combination involves elements that are incompatible or mutually exclusive. The sequential order of the acts in any process described herein may be rearranged, unless the context clearly dictates otherwise, such as if one act requires the result of another act as input.

In the interest of conciseness, and for the sake of continuity in the description, same or similar reference characters may be used for same or similar elements in different figures, and description of an element in one figure will be deemed to carry over when the element appears in other figures with the same or similar reference character. In some cases, the term "corresponding to" may be used to describe correspondence between elements of different figures. In an example usage, when an element in a first figure is described as corresponding to another element in a second figure, the element in the first figure is deemed to have the characteristics of the other element in the second figure, and vice versa, unless stated otherwise.

The word "comprise" and derivatives thereof, such as "comprises" and "comprising", are to be construed in an open, inclusive sense, that is, as "including, but not limited to". The singular forms "a", "an", "at least one", and "the" include plural referents, unless the context dictates otherwise. The term "and/or", when used between the last two elements of a list of elements, means any one or more of the listed elements. The term "or" is generally employed in its broadest sense, that is, as meaning "and/or", unless the context clearly dictates otherwise. When used to describe a range of dimensions, the phrase "between X and Y" represents a range that includes X and Y. As used herein, an "apparatus" may refer to any individual device, collection of devices, part of a device, or collections of parts of devices.

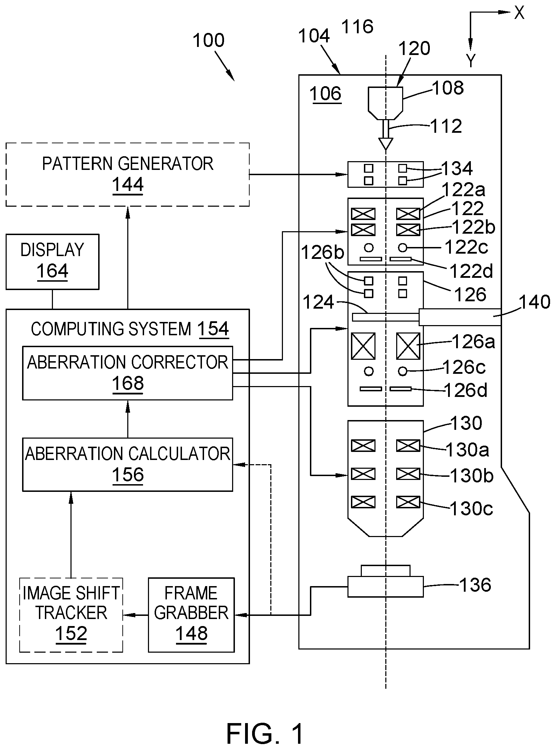

FIG. 1 illustrates a system 100, according to one implementation, that can measure and reduce or partially correct for optical aberrations in a charged particle beam microscope system while the charged particle beam microscope system is operating in a transmission imaging mode. The system 100 is illustrated in the context of an exemplary charged particle beam microscope system 104. However, the system 100 is not limited to the particular configuration of the charged particle beam microscope system 104 shown in FIG. 1 and could be used with any charged particle beam microscope system, such as a system operating in a scanning imaging mode, or otherwise.

In the illustrated example, the charged particle beam microscope system 104 includes a charged particle beam microscope column 120 (hereafter, microscope column 120) enclosed in a vacuum chamber 106. The microscope column 120 defines an optical axis 116 of the charged particle beam microscope system 104.

A sample 124 to be investigated can be disposed along the optical axis 116. The sample 124 can be supported by a sample holder 140, which in some examples can have capabilities to translate, rotate, and/or tilt the sample 124 relative to the optical axis 116. The sample holder 140 can allow different areas of the sample 124 to be positioned relative to the optical axis 116 for investigation.

At the top of the microscope column 120 is a charged particle source 108 (e.g., a thermal electron source, Schottky-emission source, field emission source, etc.) that emits a charged particle beam 112 (e.g., an electron beam). The charged particle beam 112 is directed along the optical axis 116 such that it can impinge on the sample 124 and interact with the sample 124. The charged particle beam 112 passes through the sample 124 to produce an image.

A camera 136 at the bottom of the microscope column 120 can be operated to capture an image of the sample 124. The camera 136 can include, for example, a CCD (charged-coupled device) imaging sensor, a CMOS (complementary metal-oxide-semiconductor) imaging sensor, or, more generally, an array of photodetectors. In one example, the camera 136 can be operable in a "movie" mode to capture a sequence of images of the sample.

The microscope column 120 can include various charged particle beam lens systems (hereafter, lens systems) that direct the charged particle beam 112 along the optical axis 116 and configure the charged particle beam 112 to provide a constant illumination covering a desired field of view on the sample 124. In some examples, the various lens systems can also project the image produced by interaction of the charged particle beam 112 with the sample 124 into a field of view of the camera 136.

In some examples, the various lens systems can include a condenser lens system 122, an objective lens system 126, and a projector lens system 130, which can have any suitable configuration to modify the charged particle beam 112 to provide a desired field of view. The condenser lens system 122 can be configured to condense the charged particle beam 112 into a nearly parallel beam. The objective lens system 126 can be configured to focus the image formed by transmitting the charged particle beam 112 through the sample 124. The projector lens system 130 can be configured to project the image coming from the objective lens system 126 to the field of view of the camera 136.

In some examples, the condenser lens system 122 can include condenser lenses 122a, 122b and other components, such as a condenser stigmator 122c (i.e., a device to correct axial astigmatism), and a condenser aperture 122d.

In some examples, the objective lens system 126 can include an objective lens 126a and other components, such as beam deflectors 126b (which can be used to centre the beam), an objective stigmator 126c (i.e., a device to correct axial astigmatism), and objective aperture 126d. In the illustrated example, the sample 124 is positioned above the objective lens 126a (in other examples, the sample 124 can be inserted into the objective lens 126a).

In some examples, the projector lens system 130 can include, for example, an intermediate lens 130a (e.g., to magnify the image) and projector lenses 130b, 130c. The projector lens system 130 can include other components, such as a stigmator, image deflector, and aperture.

The components of the lens systems can be electro-optical components that are tuneable by varying the electrical current applied to the components. For example, the various lenses of the lens systems 122, 126, 130 can be electromagnetic lenses. An electromagnetic lens modifies charged particle beams by a magnetic field generated by a solenoid. By changing the electric current to the solenoid, the magnetic field can be changed, which would correspondingly change the focal length and magnification of the lens. The other components of the lens systems 122, 126, 130, such as the stigmators and beam deflectors, can be electromagnetic devices, which can be tuned in the same manner as described for the electromagnetic lenses. The ability to tune the components of the lens systems 122, 126, 130 by varying electrical current supplied to the components can allow aberration corrections to be applied to the microscope column 120 on-the-fly (e.g., while the charged particle beam microscope system 104 is operating in a transmission imaging mode).

The lens systems 122, 126, 130 can include other optical components not shown in FIG. 1 or a different configuration of optical components. The microscope column 120 can include other optical components near the output of the charged particle source 108. For example, the microscope column 120 can include an accelerator stack that can be used to increase the acceleration of the charged particle beam 112 (e.g., prior to condensing the charged particle beam 112).

In some specific examples relating to measuring aberrations with an image of a test pattern, the system 100 may include a pattern generator 144 that can generate various patterns. The pattern generator 144 can be, for example, a programmable function generator. In some examples, the pattern generator 144 can be configured to generate periodic patterns. In one example, the periodic pattern can be a Lissajous figure. Lissajous figure is given by the following parametric equations:

$$x = A \sin(at + \delta) \tag{1}$$

$$y = B \sin(bt) \tag{2}$$

The Lissajous figure can be as simple as a circle (e.g., the parametric equations (1) and (2) give a circle when a/b = 1, A = B, and $\delta = \pi/2$ radians) or can be more complex (e.g., the ratio a/b is not equal to 1).

In such examples comprising test patterns, the system 100 may include beam deflectors 134 inserted in the microscope column 120. The beam deflectors 134 can be controlled according to the pattern to tilt the charged particle beam 112 in the X and Y directions over time. The beam deflectors 134 can apply tilt motion to the charged particle beam 112 prior to the charged particle beam 112 reaching the sample 124 (e.g., prior to condensing the charged particle beam 112). The beam deflectors 134 can be electro-optic deflectors (e.g., electrostatic or magnetic beam deflectors), which would allow the tilt angles applied to the charged particle beam 112 to be changed by varying the electrical current to the beam deflectors.

The beam deflectors 134, operated according to a pattern, apply a time series of beam tilts to the charged particle beam 112. Each beam tilt produces an image. Thus, the time series of beam tilts results in a sequence of images. Image shifts between successive (or adjacent) images in the sequence of images can indicate optical aberrations in the microscope system.

The system 100 can include a frame grabber 148 in communication with the camera 136. The frame grabber 148 can, for example, form an interface between the camera 136 and a computing system 154 (e.g., a server). The frame grabber 148 is an electronic device that can capture individual image frames from a stream of image data produced by the camera 136.

In such examples relating to image shift methods of acquiring an aberration measurement, the system 100 can include an image shift tracker 152 in communication with the frame grabber 148. The image shift tracker 152 can receive image frames from the frame grabber 148 and measure (or compute) the image shift between successive image frames over time. The image shift tracker 152 can use any suitable imaging processing technique to measure images shift. One example technique is cross-correlation. In one example, the image shift tracker 152 can be executed by a processor (e.g., GPU, CPU, or FPGA) of the computing device 154.

The computing system 154 also acquires or otherwise receives aberration predictor values corresponding to the image frames received from the frame grabber 148. The aberration predictor values are preferably received with each of the plurality of images acquired by the frame grabber and may refer to any parameters on which aberrations may be dependent or parameters from which an aberration determination may otherwise be predicted. For example, aberration predictor values may refer to a two-dimensional position reading of an image beam shift, a time stamp, a temperature, a sensor measurement from a surface of the imaging system, or any other environmental or operational variables which may impact the imaging system or the optical state. Any of these key parameters are inputted to the computing system 154 alongside their respective received image frames.

The system 100 can include an aberration calculator 156 that determines values for the optical aberrations in a charged particle beam microscope system. The optical aberration may be determined, for example, from Thon ring analysis or from the measured image shifts from a series of images acquired while varying the beam tilt using a pattern; from one or more parameters characterizing aberrations; or from one or more images which can be processed to obtain aberration parameters. Examples of optical aberrations that can be found in charged particle beam microscopes and measured are defocus, two-fold astigmatism, three-fold astigmatism, four-fold astigmatism, five-fold astigmatism, sixfold astigmatism, axial coma, fifth order axial coma, spherical aberration, sixth order spherical aberration, star aberration, sixth order star aberration, three-lobe aberration, rosette aberration, linear distortion, pincushion distortion, barrel distortion, spiral distortion, and elliptical distortion. The aberration calculator 156 can be configured to determine values for any combination of these optical aberrations as well as other optical aberrations not specifically mentioned.

In one example, the aberration calculator 156 can receive a data acquisition or charged particle microscope image from the computing system 154 and measure the optical aberration in the microscope column 120 based thereon. In one example, the aberration calculator 156 can estimate the optical aberrations from an image shift tracker 152 which fits image shifts to an optical aberration function that provides a relationship between parameters of an image shift, e.g., between test pattern image shifts, beam tilts, and optical aberrations in the microscope column 120. In some examples, the optical aberration function can be extended with one or more auxiliary parameters that are also fitted.

In one example, the aberration calculator 156 can receive the image data directly from the camera 136 or receive image frames from the frame grabber 148. The aberration calculator can process the image data to measure aberrations using any of the multitude of techniques known in the art, for example, J. Barthel, A. Thust, Aberration measurement in HRTEM: Implementation and diagnostic use of numerical procedures for the highly precise recognition of diffractogram patterns, Ultramicroscopy, Volume 111, Issue 1, 2010, Pages 27-46.

The aberration calculator 156 fits an aberration model for predicting aberration data, according to the methods described herein. With reference to FIG. 1, the aberration calculator 156 uses sets of aberration predictor values from the computing system 154 obtained during data acquisition and the known corresponding aberration measurements determined by the aberration calculator 156. In particular, the aberration calculator 156 fits a model (e.g., a parametric model) which, when obtained, takes a set of aberration predictor values as input and outputs predicted aberration data. The predicted aberration data may be value(s) indicating corresponding aberration(s) or may be value(s) parameterising corrections to be applied to acquired images.

The system 100 can include an aberration corrector 168 that is communicatively coupled to the aberration calculator 156. The aberration corrector 168 takes the predicted aberration data, corrects the received images and/or adjusts the instrumentation within optical system, and obtains a sample reconstruction from the (corrected) images. For example, the predicted aberration data may specify the correction (e.g., image data correction and/or system adjustment) and the aberration corrector 168 applies that correction and/or system adjustment. Alternatively, the predicted aberration data may indicate or characterise one or more predicted aberrations, the aberration corrector 168 receives the predicted aberration data from the aberration calculator 156 and determines a correction or adjustment for the relevant one or more aberrations therefrom. Once the correction or adjustment is determined, the aberration corrector 168 applies the correction to the respective image data or to the optical system (i.e., to the microscope column). For example, the aberration corrector 168 can apply adjustments to the components of the microscope column 120 (e.g., the components of the lens systems) based on the predicted aberration data determined by the aberration calculator 156 to reduce aberrations. In particular, where the components are electro-optical components, the aberration corrector 168 can change the electrical current applied to the components in order to change how the components modify the charged particle beam 112. In some examples, the aberration corrector 168 can apply the adjustments to the components of the microscope column 120 based on predetermined conditions (e.g., if the optical aberrations exceed predetermined thresholds or if the confidence of an estimated aberration value exceeds a predetermined threshold (e.g., if the absolute value of an estimated aberration value is less than a confidence interval for that optical aberration)).

In some examples, the aberration calculator 156 and aberration corrector 168 can be programs or scripts running on the computing system 154. The aberration corrector 168 can be in communication with the aberration calculator 156. In some examples, the computing system 154 can be coupled to a display 164 (e.g., a console of the charged particle beam microscope system 104). In some examples, the computing system 154 can present current aberration values and trends in the aberrations on the display 164.

The aberration calculator 156 and aberration corrector 168 can be implemented in software and/or hardware. Software components of the aberration calculator 156 and aberration corrector 168 can be stored in one or more computer-readable storage media or computer-readable storage devices and executed by one or more processors (e.g., processors in the computing system 154). Any of the computer-readable media herein can be non-transitory (e.g., volatile memory such as DRAM or SRAM, non-volatile memory such as magnetic storage, optical storage or the like) and/or tangible. It will be appreciated that the system 100 can include one or more computing systems. For example, the different programs or scripts of the methods disclosed herein (e.g., the aberration calculator 156 and corrector 168 of computing system 154) may be shared across a plurality of computing systems (or servers) communicatively coupled to one another to individually carry out the different programs or scripts.

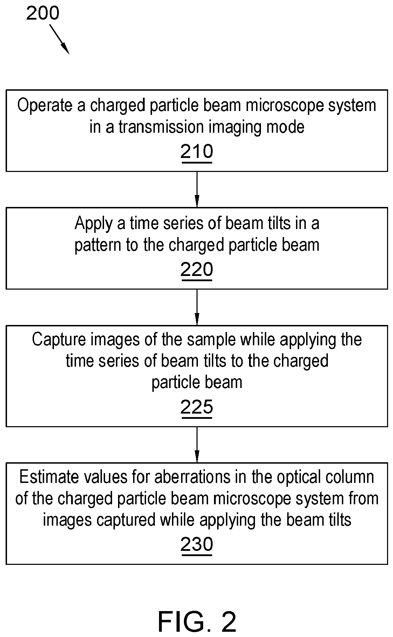

FIG. 2 is a flow diagram illustrating an example method 200 of measuring optical aberrations in a charged particle beam microscope system (e.g., the charged particle beam microscope system 104 illustrated in FIG. 1) using a time series of beam tilts in a pattern and acquiring a corresponding sequence of microscope images. This is one method of measuring values that characterise an aberration and it will be understood that other measurements for making such measurement can be used instead in the disclosed methods of aberration corrections and in particular in fitting or training an aberration model. Operations are illustrated once each and in a particular order in FIG. 2, but the operations may be reordered and/or repeated as desired and appropriate (e.g., different operations performed may be performed in parallel, as suitable).

At 210, the method includes operating a charged particle beam microscope system in an imaging mode (e.g., transmission imaging). The operation 210 can include generating a charged particle beam (e.g., an electron beam) using a charged particle source at the top of the microscope column and directing the charged particle beam to a sample using optical components in the microscope column. The charged particle beam interacts with the sample to produce an image. The operation 210 can include projecting the image into a field of view of a camera at the bottom of the microscope column.

At 220, with the charged particle beam microscope system operating in the transmission imaging mode as described in operation 210, the method can include applying a time series of beam tilts in a pattern to the charged particle beam coming out of the charged particle source. The operation 220 can include generating the pattern. The operation 220 can include applying the time series of beam tilts by traversing the pattern. At each point on the traversal path, the x, y coordinates of the point determine the amount of tilt to apply to the charged particle beam in the X and Y directions. The tilt amounts can be used to control the beam deflectors inserted in microscope column to tilt the beam. In some examples, the pattern can be a periodic pattern. In some examples, the periodic pattern can be a Lissajous figure (or Lissajous curve).

At 225, while applying beam tilts to the charged particle beam as described in operation 220, the method can include operating a camera in a movie mode to capture images of the sample. For every beam tilt, the camera can obtain a full image of the sample. Thus, the camera can capture a sequence of images corresponding to applying the time series of beam tilts to the charged particle beam. The time between applying the beam tilt and the actual tilting of the beam can vary such that there is an unknown time delay between the beam tilting pattern and the sequence of images captured. In some examples, the optical aberration function can incorporate the unknown time delay as an auxiliary variable to be fitted. Other auxiliary variables can be incorporated in the optical aberration function as well, e.g., beam tilt pattern or sample drift.

At 230, the method can include acquiring aberration measurements for the optical aberrations in the microscope column from the images captured in operation 225. In one example, the optical aberrations can be estimated from an optical aberration function that relates image shifts to beam tilts and optical aberrations of the microscope column. In another example, the optical aberrations can be obtained by optimizing a function that provides a relationship between the sequence of images and optical aberrations in the microscope column. In another example, the optical aberrations can be obtained as an inference of a trained neural network. The inference can include the prediction of the neural network as well as other information such as confidence of the prediction.

Equation (3) below is an example of an optical aberration function. For illustrative purposes, Equation (3) can obtain values for defocus, astigmatism (astigX, astigY), coma (comaX, comaY), threefold astigmatism (threefoldX, threefoldY), spherical aberration (spherical), star aberration (starX, starY), and fourfold astigmatism (fourfoldX, fourfoldY).

$$
\begin{pmatrix} shiftX \\ shiftY \end{pmatrix} = \left\{ \begin{matrix} \begin{vmatrix} tx \\ ty \end{vmatrix} \begin{vmatrix} tx \\ -ty \end{vmatrix} \begin{vmatrix} ty \\ tx \end{vmatrix} \begin{vmatrix} tx^2 + \frac{ty^2}{3} \\ \frac{2\,tx\,ty}{3} \end{vmatrix} \begin{vmatrix} \frac{2\,tx\,ty}{3} \\ \frac{tx^2}{3} + ty^2 \end{vmatrix} \begin{vmatrix} tx^2 - ty^2 \\ -2\,tx\,ty \end{vmatrix} \begin{vmatrix} 2\,tx\,ty \\ tx^2 - ty^2 \end{vmatrix} \cdots \\ \\ \cdots \begin{vmatrix} tx(tx^2 + ty^2) \\ ty(tx^2 + ty^2) \end{vmatrix} \begin{vmatrix} tx^3 \\ -ty^3 \end{vmatrix} \begin{vmatrix} \frac{1}{2}(3\,tx^2 ty + ty^3) \\ \frac{1}{2}(tx^3 + 3\,tx\,ty^2) \end{vmatrix} \begin{vmatrix} tx^3 - 3\,tx\,ty^2 \\ -3\,tx^2 ty + ty^3 \end{vmatrix} \begin{vmatrix} 3\,tx^2 ty - ty^3 \\ tx^3 - 3\,tx\,ty^2 \end{vmatrix} \end{matrix} \right\} \cdot \begin{pmatrix} defocus \\ astigX \\ astigY \\ comaX \\ comaY \\ threefoldX \\ threefoldY \\ spherical \\ starX \\ starY \\ fourfoldX \\ fourfoldY \end{pmatrix} \qquad (3)
$$

The vector on the right-hand side of the equation contains values for optical aberrations for a given state of the optical system of the microscope system at a certain moment in time. When the tilt of the beam is adjusted with (tx, ty) radians, then the induced image shift will be given by (shiftX, shifty), which can be measured from images captured while applying the beam tilts (e.g., in operation 240). The measured shiftX, shiftY and known tx, ty can be fitted into the function of Equation (3) to obtain the estimated values for the optical aberrations. The parameters tx, ty are time-dependent, which allows unknown time delay between the applied beam tilt pattern and the induced image shift pattern to be factored into the function for fitting. Variations of the optical aberration function can incorporate other auxiliary parameters, such as beam tilt pattern and/or sample drift.

The operations 220-230 can be repeated each time an aberration measurement is due during a planned acquisition or each time predetermined criteria for an aberration measurement are met during a planned acquisition. The aberration measurements over time can be displayed on a screen and monitored.

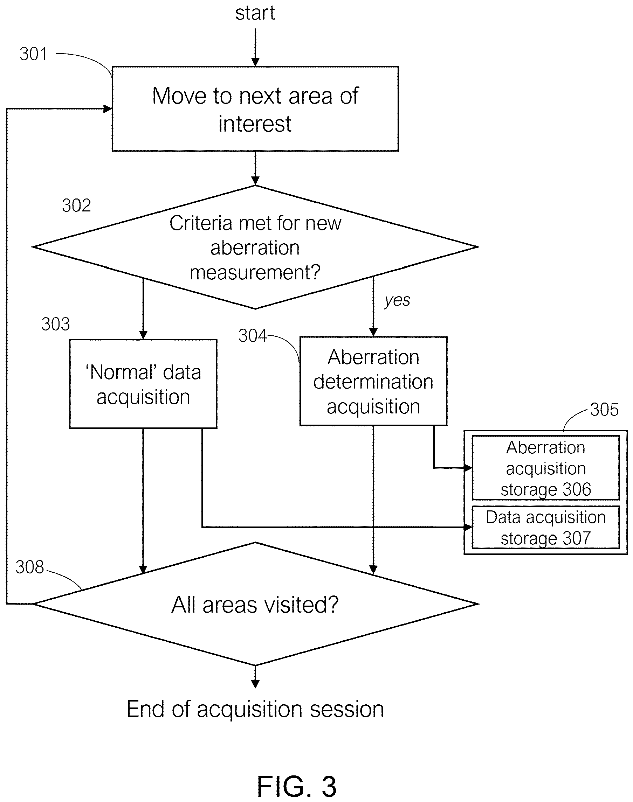

FIG. 3 illustrates an example workflow for acquiring acquisitions of a sample, for example a sample containing instances of a particle to be reconstructed. The workflow is part of a larger (automated or manual) workflow in which a multitude of (programmed or dynamically changing) sample positions are navigated to, with the goal to acquire a high resolution sample reconstruction. At 301, the method comprises moving to a new area of interest of the sample. With reference to FIG. 1, it will be understood moving to a new area of interest on a sample refers to moving to a new area along an optical axis of the charged particle beam microscope system. Various specific workflows for moving from a first area of interest on a sample to a next are known in the art and may be used to implement the methods described herein. For example, the step 301 may comprise translating and/or tilting the sample 124 and/or the beam 112 relative to the optical axis 116 to a first or another area of interest of the sample 124. In some examples, the beam is kept stationary during data acquisition and a grid containing the sample is shifted or translated to facilitate images of a new area of interest.

At step 302, the method comprises assessing if a new aberration acquisition is needed, i.e., if criteria for a new aberration measurement is met. The criteria for a new aberration measurement may comprise, for example: when another measurement is scheduled (such as a defocus measurement), when the last measurement is a specified amount of time ago, when more information on aberrations in another area of the two-dimensional optical axis is acquired, or if a change in one or more environmental or operational variables are detected, e.g., if a temperature change is detected, if a change in sample position (e.g., a change in relative height of the sample) is detected, or otherwise. It will be understood that step 302 may also refer only to a singular criterion. The new aberration acquisition may comprise an image of a test pattern with distortion indicative of aberration (e.g., using the example method illustrated in FIG. 2), one or more images which can be processed to obtain one or more aberration parameters, and/or a parameter characterizing aberration, as discussed above.

If it is assessed that a new aberration acquisition is not needed, the method proceeds to step 303. At step 303, the method comprises acquiring a data acquisition for use in reconstructing an image or model of the particle and acquiring one or more aberration predictor values. For example, the data acquisition can comprise a low-dose high-resolution image acquisition at a selected area of the sample and a predictor value can comprise a temperature measurement. The one or more predictor values are stored in association with the data acquisition (for example in the metadata of the data acquisition) in data acquisition storage 307.

If a new aberration acquisition is due, the method progresses to step 304, which comprises acquiring an aberration acquisition for measuring one or more aberrations and acquiring one or more associated predictor value(s) for the aberration(s). Both acquisitions are stored in aberration acquisition storage 306. Optical aberrations can be measured using a relatively small amount of data (e.g., defocus), or a relatively large amount of data may be required for appropriate measurement (e.g., coma and astigmatism). The one or more predictor values are stored in association with the aberration acquisition (for example in the metadata of the aberration acquisition) in data acquisition storage 306. It will be appreciated that the metadata of the data acquisition may also comprise other values that are not necessarily relevant to the aberrations but may be otherwise relevant for good sample reconstruction, such as a high-tension value, a pixel size, or other system state parameters.

The aberration predictor values, associated and stored with the acquisitions of steps 303 and 304 respectively, refer to any parameters on which aberrations might depend or parameters from which an aberration may be predicted. For example, aberration predictor values may refer to a two-dimensional position reading of an image beam shift, a time stamp, a temperature, a sensor measurement from a surface of the imaging system, a sample position, or any other environmental or operational variables which may impact the imaging system or the optical state.

Steps 303 and 304 may happen simultaneously or sequentially. For example, if the criteria are met for a new aberration measurement, a new data acquisition may be made alongside an aberration determination acquisition, for example using one and the same exposure. In some examples, the aberration measurement at step 304 may be carried out following a data acquisition at step 303. In this way, the first part of the exposure is used for the acquisition of the charged particle microscope image, which is beneficial for samples which are radiation sensitive.

Once a particular area of the sample has been visited and the method progresses to step 308. The method 308 comprises a check of whether all areas of interest of the sample have been visited. If "no", the method returns to method step 301, i.e., moving to a next area of interest on the sample and repeating the workflow as described above. If all areas of interest of the sample have been reach, the sample acquisition run is ended.

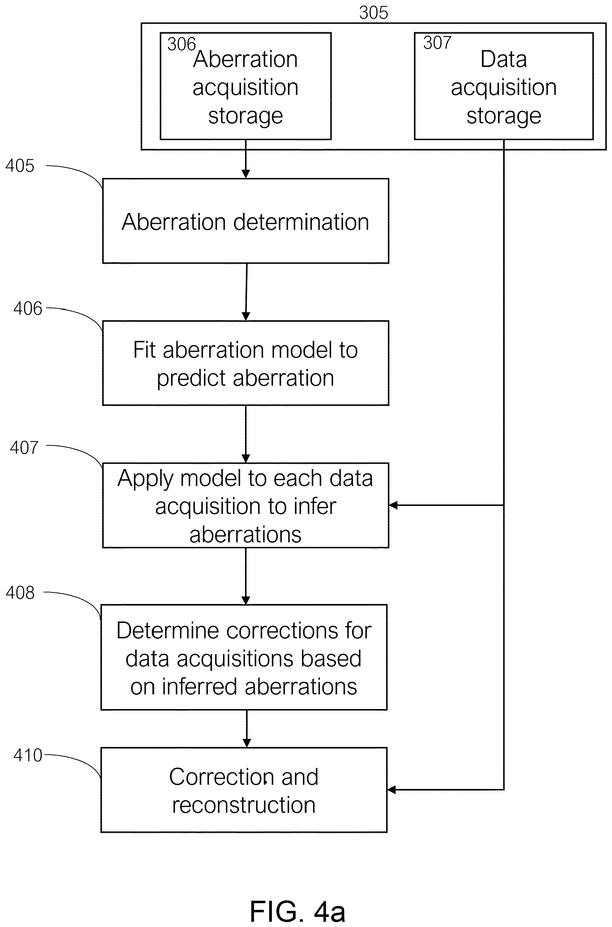

FIG. 4a illustrates an example workflow for obtaining an aberration model from stored pairs of aberration acquisitions and acquired aberration predictor values, and using the model to reduce or at least partially correct for aberrations. At step 405, the aberration acquisition storage 306 is accessed and one or more aberration measurements are determined from the respective stored aberration acquisitions. For example, the aberration measurement may be a value or qualification of a coma aberration present in the respective image. Methods for determining an aberration measurement from an aberration acquisition are known in the art, and one specific example method is discussed above and illustrated in FIG. 2.

At step 406, a model is fit, using the pairs of aberration measurements and corresponding aberration predictor values, to predict aberration measurements from the aberration predictor values. The method includes initialising a model, which may be, for example, a parametric model, a physical model, a statistical model, a linear model, a polynomial model, a decision tree, a random forest, a neural network, or a machine learning model. The aberration model takes a set of aberration predictor values as an input and outputs a predicted aberration measurement. The model is trained by obtaining predicted aberration measurements from aberration predictor values, comparing the predicted measurements to the actual aberration measurements, and adjusting parameters of the model to reduce a discrepancy between the predicted measurements and the actual measurements. Various methods of training the model are known in the art and may be used to implement the methods disclosed herein. For example, the parameters of the model may be trained using suitable optimization techniques, such as gradient descent.

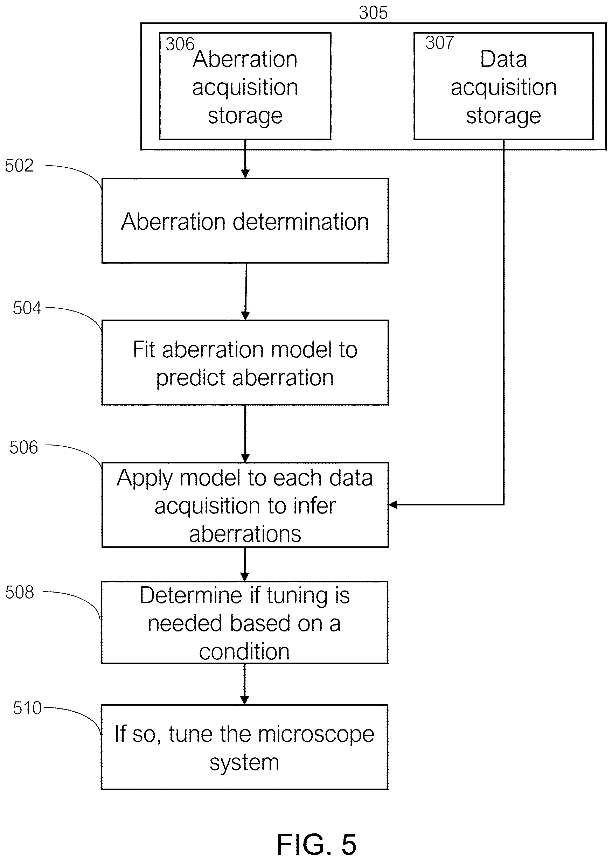

Once the model is fitted, the data acquisition storage 307 is accessed at step 407 and the acquired predictor values during an acquisition input into the model for inference to obtain aberration measurements for each acquisition. For example, the aberration model may infer that there is a $10\mu m$ coma aberration present from a given set of aberration predictor values. At step 408, corrections for the aberration measurements output by the model are determined respectively for each data acquisition. Determining a correction for a given aberration measurement is known in the art, and may comprise, for example, a Fourier filter to correct for phase flips and/or phase changes caused by the predicted aberration measurements, a transformation or a distortion field which corrects for distortions caused by the predicted aberration measurements, or a tuning adjustment to the microscope column as will be described in more detail below with reference to FIG. 5. At 410, data corrections are applied to the respective data acquisitions in a final step 410 and the data is reconstructed to acquire a full resolution, model, or image of the particle.

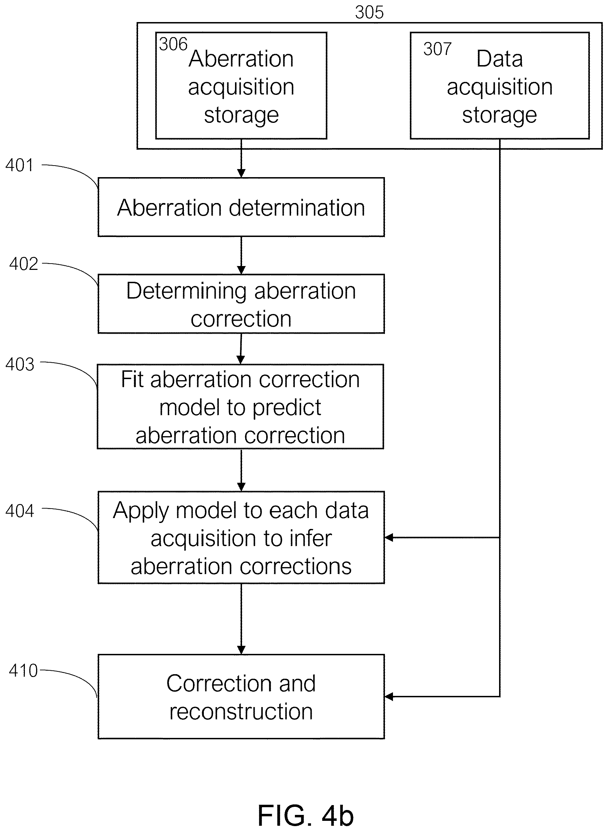

FIG. 4B illustrates an alternative example for obtaining an aberration model. Step 401 is the same as step 405 described in FIG. 4A. At step 402 an aberration correction is determined from the aberration measurements obtained at step 401 for each aberration acquisition, using methods known in the art. Corresponding pairs of one or more parameter values defining the aberration correction for each aberration acquisition and the corresponding aberration predictor values are obtained. The aberration model at step 403 is fitted using the obtained pairs from step 402. During training, the output aberration correction parameters output by the model are compared with the corresponding known aberration correction parameters obtained at step 402. The parameters of the model are then updated to reduce an error between the output correction parameters and the known aberration correction parameters. It will be understood that, whilst the inputs and the outputs of the model of FIG. 4b necessarily differ to the model of FIG. 4a, the model may otherwise be the same as described above.

At step 404, the data acquisition storage 307 is accessed and the set of predictor values for each reconstruction acquisition are input into the model for inference to obtain respective aberration corrections. The inferred corrections are applied to the respective data acquisitions and the corrected reconstruction acquisitions are used to reconstruct an image or a model of the particle in a final step 410.

The workflows of FIGs 3 and 4 may be carried out individually or simultaneously and may be run independently or interdependently. In some examples, the workflow of FIG. 3 may be first carried out to obtain image acquisitions and aberration data, which are subsequently fed through the steps of FIGs. 4a or 4b to fit an aberration model for aberration correction to apply to the data acquisitions for reconstruction. In this way, the distortive effects of aberrations during data acquisition can be corrected in a post-processing workflow, obviating the need for on-the-fly correction of aberrations while the images are acquired. In other examples, the fitting and correction workflows of FIGs. 4a or 4b may be carried out on-the-fly during data acquisition, e.g., in order to limit processing latency.

FIG. 5 illustrates an example workflow for obtaining an aberration model from stored pairs of aberration acquisitions and acquired aberration predictor values, and using the model to tune the charged particle beam microscope system to mitigate aberration. In particular, the workflow of FIG. 5 involves determining adjustments to be applied to the optical column of the charged particle beam microscope system to reduce one or more aberrations during the acquisition session (i.e., prior to sample reconstruction). In order to feed the output adjustments through to the elements of the microscope and to reduce aberration during image acquisition, the workflows of FIG. 3 and FIG. 5, in some implementations, run substantially simultaneously. In this way the model is obtained, and the relevant data processed, 'on-the-fly', once sufficient data has been collected to achieve a suitable prediction performance of the model, for example as measured by a RMS error determined on test data not used for training the model. In some embodiments, the model is pre-trained and loaded at the beginning of the workflow in order to enable on-the fly correction earlier or even from the outset.

The steps of workflow of FIG. 5 may also be combined with, shared with, or may otherwise run at the same time as the workflows of FIG. 4a or 4b, such that aberrations can be addressed both by correction to the acquisition image and by adjustment to the microscope system. In particular, if the predicted aberrations, e.g., as determined at steps 407 or 404 of FIGs. 4a and 4b respectively, meet a condition indicating that the charged particle microscope system needs to be tuned or that the predicted aberrations may be more optimally reduced or corrected for with an adjustment to the microscope column (rather than just in data processing), then the workflow may jump from FIG. 4 to FIG. 5 whereby the subsequent correction step may comprise tuning the charged particle microscope system. It will be appreciated that, in examples relating to the operative cooperation of FIGs. 4 and 5, adjustments to the microscope may result in a sudden change of expected aberration values which should be accounted for in the fitted model of FIGs. 4a or 4b. This can for example be done by including a step function over time in the aberration model. Alternatively, two separately fitted aberration models can be obtained and applied respectively before and after the microscope change.

In some examples, the workflows of FIGs. 4a or 4b may be combined with the workflow of FIG. 5 by using two models, e.g., running in parallel or one model running on-the-fly and the other in post-processing. The two models may correspond to each respective type of aberration prediction as discussed herein. For example, in examples where the model directly predicts an image correction and/or a system adjustment, a first model may correspond the workflow of FIG. 4b and infer aberration corrections for the data acquisitions, whilst a second model may correspond to the workflow of FIG. 5 and infer system adjustments to apply to the charged particle microscope system. Alternatively, in some examples, the method comprises only one model, e.g., a model to infer one or more aberrations present in an aberration acquisition, and the method runs the workflows of FIGs. 4a and 5 with the same model. Other operative combinations of the workflows of FIGs. 3, 4a, 4b, and 5, using one or more models running in parallel, on-the-fly, or in post-processing, are equally envisaged and encompassed by the present disclosure.

Step 502 may be the same or similar to steps 401 and 405 of FIGs. 4a and 4b. In particular, aberration data (e.g., characterising the type and the properties of one or more aberrations present, or characterising the adjustments to the charged particle beam microscope system to reduce aberrations present) is determined from the stored aberration acquisition, using techniques known in the art. At step 504, an aberration model is fitted using pairs of the aberration data and the aberration predictor values of each corresponding aberration acquisition. The training of the model may be similar to as described in FIGs. 4a and 4b. During training, the predicted aberration data output by the model is compared with the corresponding known aberration data obtained at step 502. The parameters of the model are then updated to reduce an error between the output predicted aberration data and the known (measured) aberration data. The model and model training process may be shared between the workflows of FIG. 4 and FIG. 5 where the same kind of aberration data is predicted, for example aberration data identifying the aberration.

At step 506, each data acquisition is input into the model for inference to obtain predicted data about aberrations present in the data acquisition. At step 508, it is determined whether the predicted aberration data output by the model for each data acquisition meets certain criteria or conditions indicating that the charged particle beam microscope system needs to be tuned or that aberrations need to be reduced. For example, the predicted aberration data may comprise an estimated quantification of a type of aberration present in the data acquisition. Alternatively, the predicted aberration data may define an adjustment value (e.g., a voltage or current change) to be applied to one or more elements of the charged particle beam microscope system to reduce aberration. The criteria may comprise determining whether the predicted aberration data is within a confidence interval for the predicted aberration and/or whether the absolute value of the predicted aberration or absolute value of the adjustment value exceeds a predetermined threshold. The predetermined threshold may refer to, for example, a maximum value of aberration that can be sufficiently corrected for in the image data using the workflow of FIG 4a or 4b, or a value of aberration above which the aberration is better mitigated with an adjustment to the microscope system.

At step 510, if the predicted aberration data exceeds the predetermined conditions, it is determined that the charged particle beam microscope system needs to be tuned. If the output predicted aberration data defines the parameters of a predicted aberration in the image, a corresponding adjustment to be applied to the charged particle beam microscope system is determined and then applied to the element(s) of the microscope system to mitigate aberrations. Similarly, if the output predicted aberration data instead defines the predicted adjustment to apply to the components of the microscope system, the adjustment is applied. By running the steps of FIG. 5 alongside a data acquisition session (e.g., FIG. 3), the charged particle beam microscope system can be continually monitored and adjusted to mitigate aberration, leading to improved images during acquisition with reduced aberrations and a higher resolution sample reconstruction. Additionally, by running the steps of FIG. 5 alongside the steps of FIG. 4, aberrations can be addressed both in the microscope system and in the images. For example, if the magnitude of an inferred aberration is below the predetermined conditions in FIG. 5, the aberration may instead be more optimally corrected for with a correction to the image acquisition data, e.g. using methods steps 408 and/or 410 of FIGs. 4a or 4b.

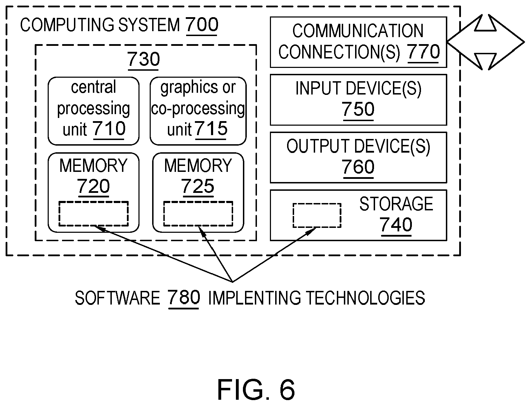

FIG. 6 is a block diagram of a generalized example computing system (or computing environment) that may be used in the methods described herein. In some examples, the methods can use a single computing system. In other examples, the methods can use multiple computing systems, which may communicate over a network.

With reference to FIG. 6, the computing system 700 includes one or more processing units 710, 715 and memory 720, 725. In FIG. 6, this basic configuration 730 is included within a dashed line. The processing units 710, 715 execute computer-executable instructions. A processing unit can be a general-purpose central processing unit (CPU), processor in an application-specific integrated circuit (ASIC) or any other type of processor. In a multiprocessing system, multiple processing units execute computer-executable instructions to increase processing power. For example, FIG. 6 shows a central processing unit 710 as well as a graphics processing unit or co-processing unit 715. The tangible memory 720, 725 may be volatile memory (e.g., registers, cache, RAM), non-volatile memory (e.g., ROM, EEPROM, flash memory, etc.), or some combination of the two, accessible by the processing unit(s). The memory 720, 725 stores software 780 implementing one or more innovations described herein, in the form of computer-executable instructions suitable for execution by the processing unit(s). Software 780 can include, for example, one or more of the aberration calculator 156, the aberration corrector 168, or the logic of the methods described herein.

A computing system may have additional features. For example, the computing system 700 can include storage 740, one or more input devices 750, one or more output devices 760, and one or more communication connections 770. An interconnection mechanism (not shown) such as a bus, controller, or network interconnects the components of the computing system 700. Typically, operating system software (not shown) provides an operating environment for other software executing in the computing system 700, and coordinates activities of the components of the computing system 700.

The tangible storage 740 may be removable or non-removable, and includes magnetic disks, magnetic tapes or cassettes, CD-ROMs, DVDs, or any other medium which can be used to store information in a non-transitory way and which can be accessed within the computing system 700. The storage 740 stores instructions for the software 780 implementing one or more innovations described herein.

The input device(s) 750 may be a touch input device such as a keyboard, mouse, pen, or trackball, a voice input device, a scanning device, or another device that provides input to the computing system 700. The output device(s) 760 may be a display, printer, speaker, CD-writer, or another device that provides output from the computing system 700.

The communication connection(s) 770 enable communication over a communication medium to another computing entity. The communication medium conveys information such as computer-executable instructions, audio or video input or output, or other data in a modulated data signal. A modulated data signal is a signal that has one or more of its characteristics set or changed in such a manner as to encode information in the signal. By way of example, and not limitation, communication media can use an electrical, optical, RF, or other carrier.

In view of the above-described implementations of the disclosed subject matter, this application discloses the additional examples enumerated below. It should be noted that one feature of an example in isolation or more than one feature of the example taken in combination and, optionally, in combination with one or more features of one or more further examples are further examples also falling within the disclosure of this application.

**Claims**

1. A method of acquiring charged particle microscope images for sample reconstruction, the method comprising:

    acquiring, using a charged particle beam microscope system, a plurality of charged particle microscope images for a plurality of areas of a sample;

    acquiring a respective first set of one or more aberration predictor values for each acquisition of the plurality of charged particle microscope images;

    periodically acquiring an aberration measurement and a corresponding second set of aberration predictor values while acquiring the plurality of charged particle microscope images;

    obtaining an aberration model using the aberration measurements and the corresponding second sets of aberration predictor values, wherein the model takes a set of aberration predictor values as an input and outputs predicted aberration data;

    applying the model to the first sets of aberration predictor values to obtain respective predicted aberration data;

    using the predicted aberration data to reduce or partially correct for aberration in the charged particle microscope images; and

    obtaining a sample reconstruction using the acquired charge particle microscope images.

2. The method of claim 1, further comprising:

    using the respective predicted aberration data to correct the charged particle microscope image of each acquisition; and

    using the corrected charged particle microscope images for sample reconstruction.

3. The method of claim 2, wherein the respective predicted aberration data characterises one or more aberrations and correcting the charged particle microscope image comprises:

    computing an aberration correction for the charged particle microscope image from the respective predicted aberration data; and

    correcting the charged particle microscope image using the computed aberration correction.

4. The method of claim 2, wherein the respective predicted aberration data comprises an aberration correction for applying to the charged particle microscope image.

5. The method of any one of claims 1 to 2, further comprising:

    determining if the predicted aberration data meets a condition indicating that the charged particle beam microscope system needs to be tuned; and

    in response to determining that the condition is met, tuning the charged particle beam microscope system to reduce aberration;

6. The method of claim 5, wherein the predicted aberration data characterises one or more aberrations and tuning the charged particle beam microscope system comprises:

    computing an adjustment for the charged particle beam microscope system from the predicted aberration data; and

    tuning the charged particle beam microscope system using the adjustment.

7. The method of claim 5, wherein the predicted aberration data comprises an adjustment for tuning to the charged particle beam microscope system.

8. The method of any one of claims 5 to 7, the method comprising periodically predicting aberration data and determining if the condition is met while acquiring images and, subsequent to tuning the charged particle beam microscope system, continuing to acquire images.

9. The method of any preceding claim wherein the predicted aberration data characterises or reduces or partially corrects for a coma aberration.

10. The method any preceding claim, wherein the predicted aberration data characterises or reduces or partially corrects for a plurality of aberrations.

11. The method of any preceding claim wherein the aberration predictor values comprise one or more of:

    one or more temperature values, each temperature value corresponding to respective one or more sensors or to different acquisition times;
    a time of obtaining the data acquisition;
    an optical state of the charged particle beam microscope system;
    a measurable physical state of the charged particle beam microscope system;
    a sample position; and/or
    a position of optics of the charged particle beam microscope system.

12. The method of any preceding claim wherein an aberration measurement is triggered by a detected temperature change above a threshold value

13. The method of any of claims 1 to 11, wherein an aberration measurement is obtained for each charged particle microscope image.

14. The method of any preceding claim wherein the aberration measurement comprises one or more of the following:

    one or more images, acquired while changing one or more microscope parameters;
    one or more images which can be processed to obtain one or more aberration parameters;
    a parameter characterising aberration.

15. The method of claim 14, wherein the one or more microscope parameters is beam tilt.

16. The method of any preceding claim, wherein the sample reconstruction comprises a single particle analysis SPA reconstruction and/or a three-dimensional reconstruction.

17. An charged particle beam microscope system comprising one or more processors and one or more memories having stored thereon computer-readable instructions configured to cause the one or more processors to perform operations comprising the steps of any of claims 1 to 16.

18. A computer-readable medium comprising instructions, that, when executed by one or more data processing apparatus, cause the one or more data processing apparatus to perform operations comprising the steps of any of claims 1 to 16.

19. A method of training an aberration model for reducing or at least partially correcting for aberrations in images acquired with a charged particle beam microscope system, wherein the aberration model takes a set of predictor values as an input and produces an output of predicted aberration data, the method comprising:

    obtaining pairs of aberration measurements and corresponding sets of aberration predictor values, wherein the aberration predictor values comprise one or more of: one or more temperature values, each temperature value corresponding to respective one or more sensors or to different acquisition times; a time of obtaining the aberration measurement; a sample position; an optical state of the charged particle beam microscope system; a measurable physical state of the charged particle beam microscope system; and/or a position of optics of the charged particle beam microscope system; and

training the aberration model using the pairs.

20. The method of claim 19, wherein

a.) training comprises using the aberration measurements to train the model and the predicted aberration data characterises the aberration; or

b.) training comprises determining parameters defining a correction at least partially correcting for aberration in an image and/or an adjustment to the charged particle beam microscope system reducing aberrations corresponding to the aberration measurement and using the determined parameters to train the model, wherein the predicted aberration data characterises the correction and/or adjustment.

FIG. 1

200

```
┌─────────────────────────────────────────────┐
│  Operate a charged particle beam microscope   │
│       system in a transmission imaging mode    │
│                    210                         │
└─────────────────────────────────────────────┘
                      │
                      ▼
┌─────────────────────────────────────────────┐
│       Apply a time series of beam tilts in a   │
│       pattern to the charged particle beam     │
│                    220                         │
└─────────────────────────────────────────────┘
                      │
                      ▼
┌─────────────────────────────────────────────┐
│   Capture images of the sample while applying  │
│       the time series of beam tilts to the     │
│             charged particle beam              │
│                    225                         │
└─────────────────────────────────────────────┘
                      │
                      ▼
┌─────────────────────────────────────────────┐
│  Estimate values for aberrations in the optical│
│  column of the charged particle beam microscope│
│  system from images captured while applying the│
│                  beam tilts                    │
│                    230                         │
└─────────────────────────────────────────────┘
```

FIG. 2

start

301 — Move to next area of interest

302 Criteria met for new aberration measurement?

yes

303 'Normal' data acquisition

304 Aberration determination acquisition

305

Aberration acquisition storage 306

Data acquisition storage 307

308 All areas visited?

End of acquisition session

FIG. 3

305

306 Aberration acquisition storage

307 Data acquisition storage

405 — Aberration determination

406 — Fit aberration model to predict aberration

407 — Apply model to each data acquisition to infer aberrations

408 — Determine corrections for data acquisitions based on inferred aberrations

410 — Correction and reconstruction

FIG. 4a

305

306 Aberration acquisition storage

307 Data acquisition storage

401 — Aberration determination

402 — Determining aberration correction

403 — Fit aberration correction model to predict aberration correction

404 — Apply model to each data acquisition to infer aberration corrections

410 — Correction and reconstruction

## FIG. 4b

**FIG. 5**

COMPUTING SYSTEM 700

730

central processing unit 710

graphics or co-processing unit 715

MEMORY 720

MEMORY 725

COMMUNICATION CONNECTION(S) 770

INPUT DEVICE(S) 750

OUTPUT DEVICE(S) 760

STORAGE 740

SOFTWARE 780 IMPLENTING TECHNOLOGIES

FIG. 6

Europäisches
Patentamt

European
Patent Office

Office européen
des brevets

# EUROPEAN SEARCH REPORT

**Application Number**

EP 23 20 3083

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 044 210 A1 (JEOL LTD [JP]) 17 August 2022 (2022-08-17) ----- | 1-20 | INV. H01J37/153 H01J37/22 |
| A | US 9 312 094 B2 (AKIMA HISANAO [JP]; HIRAYAMA YOICHI [JP]; HITACHI HIGH TECH CORP [JP]) 12 April 2016 (2016-04-12) ----- | 1-20 | |
| A,D | EP 4 235 731 A1 (FEI CO [US]) 30 August 2023 (2023-08-30) ----- | 1-20 | |

**TECHNICAL FIELDS SEARCHED (IPC)**

H01J

The present search report has been drawn up for all claims

| Place of search | Date of completion of the search | Examiner |
|---|---|---|
| Munich | 11 March 2024 | Oestreich, Sebastian |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

..................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 20 3083

This annex lists the patent family members relating to the patent documents cited in the above-mentioned European search report.
The members are as contained in the European Patent Office EDP file on
The European Patent Office is in no way liable for these particulars which are merely given for the purpose of information.

11-03-2024

| Patent document cited in search report | | | Publication date | Patent family member(s) | | | Publication date |
|---|---|---|---|---|---|---|---|
| EP 4044210 | A1 | | 17-08-2022 | EP | 4044210 | A1 | 17-08-2022 |
| | | | | JP | 7250055 | B2 | 31-03-2023 |
| | | | | JP | 2022124508 | A | 26-08-2022 |
| | | | | US | 2022262595 | A1 | 18-08-2022 |
| US 9312094 | B2 | | 12-04-2016 | CN | 103718267 | A | 09-04-2014 |
| | | | | DE | 112012002805 | T5 | 03-04-2014 |
| | | | | JP | 5758728 | B2 | 05-08-2015 |
| | | | | JP | 2013030278 | A | 07-02-2013 |
| | | | | US | 2014231666 | A1 | 21-08-2014 |
| | | | | WO | 2013015102 | A1 | 31-01-2013 |
| EP 4235731 | A1 | | 30-08-2023 | CN | 116666180 | A | 29-08-2023 |
| | | | | EP | 4235731 | A1 | 30-08-2023 |
| | | | | JP | 2023126181 | A | 07-09-2023 |
| | | | | US | 2023274908 | A1 | 31-08-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 4235731 A1

**Non-patent literature cited in the description**

- **BARTHEL J** ; **THUST A**. Aberration measurement in HRTEM: implementation and diagnostic use of numerical procedures for the highly precise recognition of diffractogram patterns. *Ultramicroscopy*, 2010, vol. 111 (1), 27-46

- **J. BARTHEL** ; **A. THUST**. Aberration measurement in HRTEM: Implementation and diagnostic use of numerical procedures for the highly precise recognition of diffractogram patterns. *Ultramicroscopy*, 2010, vol. 111 (1), 27-46